# FASCICULE DE BREVET EUROPEEN

(11) **EP 2 772 943 B1**
(45) Date de publication et mention de la délivrance du brevet: **17.03.2021**
(21) Numéro de dépôt: 14155318.0
(22) Date de dépôt: 17.02.2014
(51) Int. Cl.: H01L 29/94, H01L 21/334, H01L 49/02, H01L 23/522, H01L 27/02

(54) **Procédé de réalisation d'un dispositif microélectronique et dispositif correspondant**
Herstellungsverfahren einer mikroelektronischen Vorrichtung und entsprechende Vorrichtung
Method for producing a microelectronic device and corresponding device

(30) Priorité: 28.02.2013 FR 1351779
(43) Date de publication de la demande: 03.09.2014
(73) Titulaire: COMMISSARIAT À L'ÉNERGIE ATOMIQUE ET AUX ÉNERGIES ALTERNATIVES, 75015 Paris (FR)
(72) Inventeur: Sibuet, Henri, 38500 La Buisse (FR)
(74) Mandataire: Decobert, Jean-Pascal

(56) Documents cités:
- EP-A1- 0 581 475
- WO-A1-2011/090440
- US-A1- 2006 115 952
- US-A1- 2012 104 548

## Description

### DOMAINE TECHNIQUE DE L'INVENTION

La présente invention concerne en général la formation des reprises de contact électrique sur chacune des couches conductrices de structures stratifiées alternant couches isolantes et conductrices et plus particulièrement la réalisation de capacités multicouches ou de structures de routage denses.

### ÉTAT DE LA TECHNIQUE

L'industrie de la microélectronique utilise couramment des structures stratifiées de type métal/isolant/métal (MIM) où l'on empile des couches, alternativement isolantes et conductrices, notamment pour former des capacités de forte valeur à des coûts raisonnables en raison de l'économie de surface que la superposition de ces couches permet.

Des structures de ce type ont déjà été décrites notamment celles basées sur l'emploi de minces couches de céramiques séparées par des feuilles conductrices pour réaliser des capacités de forte valeur. Pour la reprise de contact latérale, afin de relier toutes les électrodes conductrices de façon à mettre les capacités individuelles en parallèle, on doit avoir recours à des moyens qui ne sont pas issus de la microélectronique. Les techniques employées sont en général compliquées et donc coûteuses comme celles décrites, par exemple, dans la demande de brevet déposée auprès de l'office américain des brevets et des marques, ou USPTO, sous la référence US 2012/0257324A1.

La réalisation pratique des structures MIM ci-dessus qui permettent, en mettant en parallèle électriquement les capacités associées à chacune des couches diélectriques multipliant ainsi, pour une même surface occupée, la valeur de la capacité, se heurte ainsi à la difficulté d'avoir à interconnecter les couches conductrices entre-elles afin de former les électrodes des capacités.

Les publications US 2012/014548 A1 et WO 2011/090440 A1 divulguent quant à elles des méthodes de fabrication de capacités avec, à partir d'une cavité dans un substrat, la formation d'empilements alternant parties conductrices et non conductrices avec un enchevêtrement en peigne de ces parties conductrices. Les dispositifs en résultant comportent des plots de connexion appliqués sur l'unique partie affleurant à la surface du substrat des parties conductrices. On peut ainsi réaliser des capacités à base de plusieurs couches conductrices, connectées entre elles en alternance (deux couches conductrices successives ne sont jamais raccordées électriquement) de sorte à offrir de fortes valeurs capacitives avec un encombrement réduit. Reste que la connectique par plots appliqués en surface implique une préparation lourde, induisant des marquages et/ou des gravures, pour fabriquer les couches conductrices.

US2006/0115952A1 présente une capacité multicouche avec des problèmes de raccordement électrique des différentes couches de l'empilement.

EP 0 581 475 A1 montre une méthode pour fabriquer des électrodes de capacités en tranchées. Pour permettre une reprise de contact sur la tranche des électrodes, ces dernières ont une physionomie très spécifique, avec un contour complexe permettant de créer des zones jointives qui augmentent la surface disponible pour le raccordement de la couche considérée.

C'est donc un objet de l'invention que de décrire un dispositif et un procédé de réalisation qui permettent de répondre à ce problème sans multiplier le nombre d'étapes du procédé et, avantageusement, en utilisant des moyens traditionnels mis en oeuvre par l'industrie de la microélectronique.

D'autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Un premier aspect de l'invention, tel que défini dans la revendication 1, est relatif à un procédé de réalisation d'un dispositif microélectronique comprenant un substrat et un empilement comprenant au moins une couche électriquement conductrice et au moins une couche diélectrique.

Il comprend de manière avantageuse les étapes suivantes :
- formation, à partir d'une face du substrat d'au moins un motif en creux par rapport à un plan de la face du substrat, la paroi du motif comportant une partie de fond et une partie de flanc, la partie de flanc étant située entre la partie de fond et la face du substrat,
- formation de l'empilement, les couches de l'empilement participant à remplir au moins partiellement le motif, l'étape de formation de l'empilement étant de préférence opérée sur toute la surface de la face du substrat,
- amincissement de l'empilement au moins jusqu'au plan de la face du substrat de sorte à exposer en totalité la tranche de ladite au moins une couche électriquement conductrice en affleurement dans un plan,
- après l'amincissement, formation d'au moins un organe de connexion électrique sur le substrat en contact avec la tranche de ladite au moins une couche électriquement conductrice tout en laissant en totalité la tranche de ladite au moins une couche électriquement conductrice en affleurement dans ledit plan, la tranche formant alors un contour fermé en affleurement dans ledit plan, ledit organe de connexion électrique étant configuré pour former une reprise de contact individuelle sur tranche de ladite couche électriquement conductrice,
caractérisé par le fait que la partie de flanc de la paroi du motif est formée avec au moins un pan incliné jusqu'à la face du substrat, le pan incliné présentant un angle d'inclinaison avec le plan de la face du substrat strictement compris entre 0° et 90° de sorte que la largeur de la tranche soit plus grande que l'épaisseur de ladite couche électriquement conductrice.

Selon l'invention on entend par microélectronique l'ensemble des techniques de microélectroniques et de nanoélectroniques.

Grâce à l'invention, les couches conductrices, alternées avec des couches isolantes, peuvent être rendues accessibles depuis l'extérieur, par la face du substrat, dans un même plan. Cela facilite nettement le travail de connexion ultérieur, les reprises de contact pouvant être réalisées dans le plan de la surface du substrat. L'amincissement se fait avantageusement grâce à une seule étape telle un aplanissement par planarisation. De même, les dépôts successifs sont avantageusement du type « pleine plaque » si bien que la fabrication est fortement simplifiée.

En outre, dans la mesure où le procédé permet d'obtenir une connexion électrique avec une ou des couches conductrices ayant leurs tranches exposées complétement en surface, on évite des étapes complexes de préparation des couches impliquant une pluralité de masques ou des gravures post-dépôt des couches. Dans un cas avantageux, l'invention peut se mettre en œuvre avec un seul masque de formation de motif définissant une seule ouverture, des dépôts successifs simplifiés et une finalisation pour la connexion électrique à la fois rapide et flexible quant aux configurations de connexion réalisables.

Un autre aspect de l'invention, défini dans la revendication 14, est relatif à un dispositif microélectronique comprenant un substrat et un empilement comprenant au moins une couche électriquement conductrice et une couche diélectrique, dans lequel le substrat comporte un motif en creux par rapport à un plan d'une face du substrat, la paroi du motif comportant une partie de fond et une partie de flanc, la partie de flanc étant située entre la partie de fond et la face du substrat, motif dans lequel est situé l'empilement, une première couche de l'empilement couvrant intégralement la cavité définie par le motif, toute autre couche de l'empilement couvrant intégralement une couche de l'empilement qui lui est immédiatement sous-jacente, la tranche de la au moins une couche électriquement conductrice étant exposée en totalité à la face du substrat en affleurement dans un plan en formant un contour fermé en affleurement dans ledit plan, la tranche étant raccordée à un organe de connexion électrique configuré pour former une reprise de contact individuelle sur ladite couche électriquement conductrice, caractérisé en ce que la partie de flanc comporte au moins un pan incliné jusqu'à la face du substrat, le pan incliné présentant un angle d'inclinaison avec le plan de la face du substrat strictement compris entre 0° et 90° configuré pour que la largeur de la tranche soit plus grande que l'épaisseur de ladite couche électriquement conductrice.

Un autre aspect de l'invention est relatif à un système comportant un circuit intégré doté au moins d'un plot de connexion dudit circuit intégré, au moins d'une plage d'entrée/sortie et au moins d'un dispositif selon l'invention dont un des organes de connexion est raccordé au plot de connexion et un autre des organes de connexion est raccordé à ladite plage.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
- La FIGURE 1 illustre le principe de réalisation d'un empilement d'un dispositif selon l'invention.
- La FIGURE 2 montre un exemple d'un empilement de couches obtenu après dépôts alternés de couches conductrices et de couches isolantes.
- La FIGURE 3 montre la structure symétrique des motifs qui est la plus généralement obtenue à l'issue des étapes précédentes.
- La FIGURE 4 illustre le résultat de l'étape d'amincissement de la surface des dispositifs qui est typiquement pratiquée à l'aide d'un polissage mécano chimique (CMP).
- La FIGURE 5 montre le résultat de l'étape où on l'on vient déposer, après CMP, une couche d'un isolant dans lequel on va pouvoir réaliser des reprises de contact des couches conductrices.
- La FIGURE 6 montre le résultat de l'ouverture des reprises de contact dans la couche d'isolant.
- La FIGURE 7 montre la réalisation des interconnexions à la surface du dispositif.
- La FIGURE 8 est une vue de dessus d'un exemple de dispositif de type capacité que l'on peut réaliser avec le procédé de l'invention.
- La FIGURE 9 illustre un exemple d'utilisation de l'invention pour réaliser un routage de connexions à haute densité.

Les dessins joints sont donnés à titre d'exemples et ne sont pas limitatifs de l'invention.

### DESCRIPTION DÉTAILLÉE DE L'INVENTION

Avant d'entamer une revue détaillée de modes de réalisation de l'invention, sont énoncées ci-après des caractéristiques purement optionnelles qui peuvent éventuellement être utilisées en association selon toutes combinaisons entre elles ou alternativement :
- la face du substrat étant électriquement conductrice, l'empilement est formé sur le substrat avec successivement au moins une alternance d'une couche isolante et d'une couche électriquement conductrice ;
- la paroi du motif est électriquement isolante et l'empilement est formé sur le substrat avec successivement au moins une alternance d'une couche électriquement conductrice, d'une couche diélectrique et d'une couche électriquement conductrice ;
- le pan incliné est une surface plane ;
- l'angle formé entre le pan incliné et le plan de la face du substrat est sélectionné entre 30° et 90° ;
- le pan incliné est formé pour s'évaser jusqu'à la face du substrat depuis la paroi du fond ;
- l'étape de formation d'un organe de connexion électrique comprend :
   - le dépôt d'un matériau électriquement isolant dans lequel on définit par photolithographie et gravure, pour au moins une tranche de couche électriquement conductrice exposée de l'empilement, au moins une ouverture pour permettre une reprise de contact électrique sur ladite tranche ;
   - le dépôt d'un matériau électriquement conducteur pour former l'organe de connexion électrique ledit dépôt étant configuré pour traverser au moins une ouverture;
   - l'empilement comprend deux couches électriquement conductrices espacées par une couche diélectrique, la au moins une ouverture étant configurée pour permettre une reprise de contact sur la tranche d'une première des deux couches électriquement conductrices sans permettre une reprise de contact sur une deuxième des deux couches électriquement conductrices.
   - il comprend une deuxième ouverture configurée pour permettre une reprise de contact sur la tranche de la deuxième des deux couches électriquement conductrices sans permettre une reprise de contact sur la première des deux couches électriquement conductrices.
   - il comprend, avant la formation de l'empilement, et après formation du motif en creux, la formation d'une couche électriquement isolante finalisant le substrat.
- l'étape de formation de l'empilement est opérée sur toute la surface de la face du substrat et dans lequel l'étape d'amincissement comprend un aplanissement ; l'amincissement peut s'arrêter sur un plan d'arrêt situé avantageusement sur ou sous la surface de la couche 150 si elle est présente ou sur ou sous la surface du substrat de base sous-jacent à la couche 150.
- les couches de l'empilement sont continues. Il s'agit donc avantageusement de couches qui couvrent toute la surface de la cavité.
- l'étape d'amincissement comprend un aplanissement.
- L'étape de formation du motif comprend une étape de gravure du substrat ;
- le procédé concerne la fabrication d'un dispositif capacitif multicouches ;
- le procédé concerne la fabrication d'un dispositif de routage et/ou d'alimentation électrique d'un composant ;
- l'organe de connexion électrique comprend au moins un premier et un deuxième contacts électriques, chacun de ces contacts permettant de relier électriquement une série distincte de couches conductrices dudit empilement, chaque série distincte de couches conductrices formant une électrode de capacité ou un routage électrique.
- les dépôts successifs sont conformes ;
- l'étape de formation du motif comprend une étape de gravure du substrat ;
- deux couches électriquement conductrices sont reliées électriquement en série avec le diélectrique de sorte à former les électrodes d'une capacité ;
- la tranche d'au moins une couche électriquement conductrice est raccordée à au moins deux organes de connexion de sorte à former un routage électrique ;
- un des deux organes de connexion est raccordable à une plage d'entrée/sortie d'un circuit intégré (CI) et l'autre des deux organes de connexion est raccordable à un plot de connexion dudit circuit intégré.
- la paroi de fond est plane,
- le substrat est conducteur et on dépose avant les dépôts successifs, une couche de matériau électriquement isolant,
- le substrat est électriquement isolant,
- l'empilement comprend plus de deux couches conductrices et au moins deux couches diélectriques intercalées chacune entre deux couches conductrices,
- le motif en creux est une cavité et comprend avantageusement deux pans inclinés sur les parties de flanc opposées relativement à la partie de fond,
- l'ensemble de la partie de flanc est incliné,
- la dernière couche des dépôts successifs est conductrice,
- la profondeur du motif est égale ou supérieure à l'épaisseur de l'empilement.

L'invention concerne aussi un système comportant un circuit intégré (CI),doté d'au moins une plage d'entrée/sortie et au moins un plot de connexion et au moins un dispositif selon l'invention dont un des premier et deuxième contacts électriques est raccordé au plot de connexion et un autre des premier et deuxième contacts électriques est raccordé à ladite plage.

Il est précisé que dans le cadre de la présente invention, les termes « sur » ou « au-dessus » ne signifient pas obligatoirement « au contact de ». Ainsi par exemple, le dépôt successif d'une pluralité de couches au-dessus d'une paroi d'une cavité formant un motif en creux ne signifie pas obligatoirement que la pluralité de couches et ladite paroi sont directement au contact l'une de l'autre, mais cela signifie que la pluralité de couches recouvre au moins partiellement la paroi en étant, soit directement à son contact, soit en étant séparée d'elle par une autre couche, telle une couche isolante, ou un autre élément.

D'une façon générale, on entend par hauteur, une dimension située suivant l'épaisseur du substrat. Le substrat comporte généralement deux faces opposées autour de son épaisseur, l'une des faces étant employée pour la réalisation de l'invention. Cette face est avantageusement plane, suivant un plan avantageusement perpendiculaire à l'épaisseur du substrat.

Le terme motif en creux s'entend de toutes configurations géométriques pour lesquelles une forme rentrante dans l'épaisseur du substrat est formée. Il s'agira en particulier d'une cavité du type trou non débouchant. Sa profondeur s'entend de sa dimension suivant l'épaisseur du substrat. Le substrat est de manière générale la partie de support servant lors des étapes de fabrication du dispositif et dont au moins une partie est conservée à l'issue de la fabrication pour participer audit dispositif.

Selon un aspect de l'invention, le motif en creux permet de déposer au moins certaines des couches conductrices en leur donnant une forme concave remontant vers la face du substrat si bien que la ou les couches considérées se retrouve, au niveau du plan de la face du substrat, orientées de sorte que leur tranche soit dans le plan de ladite face. Le terme tranche s'entend ainsi d'une portion de bordure d'une couche de l'empilement.

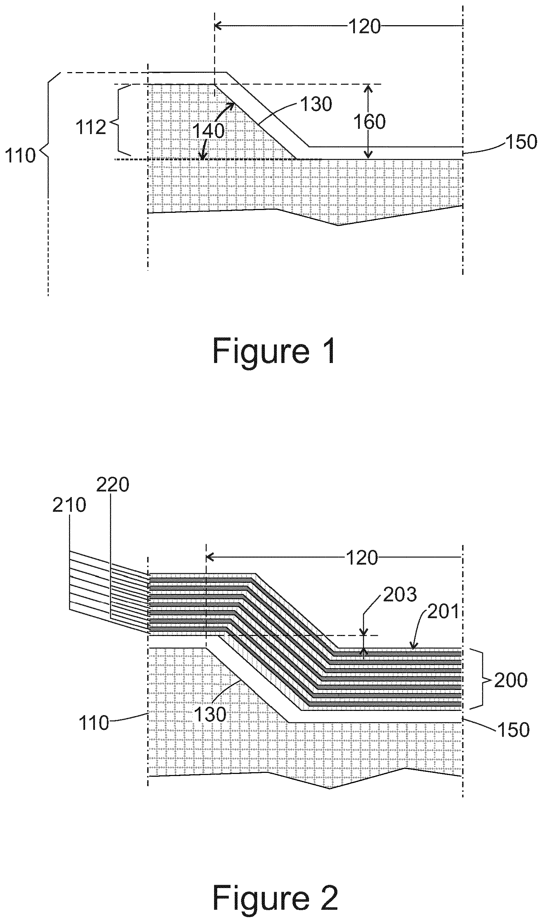

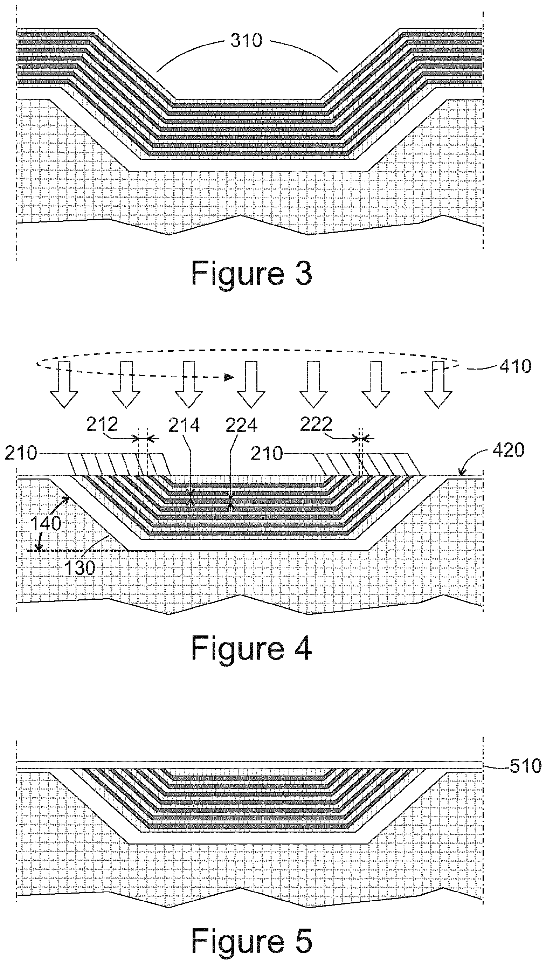

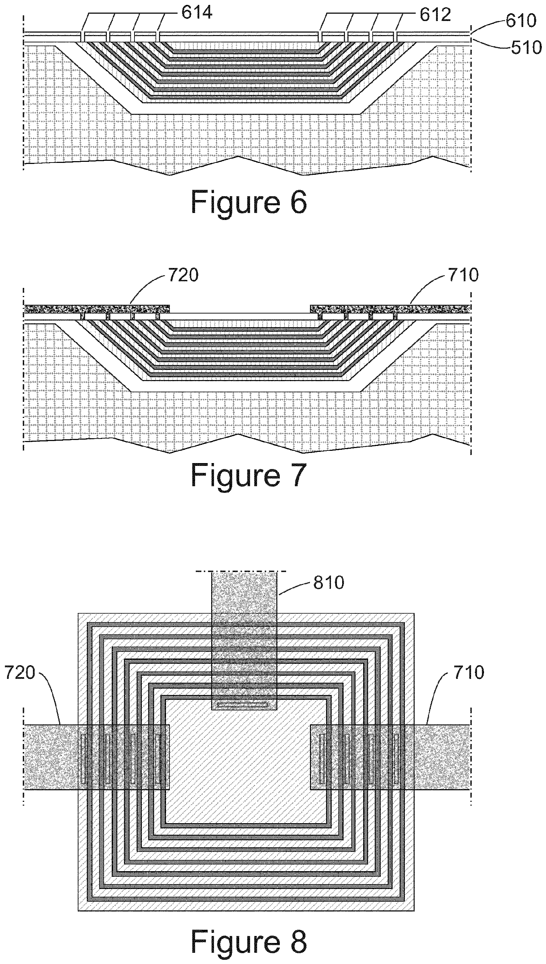

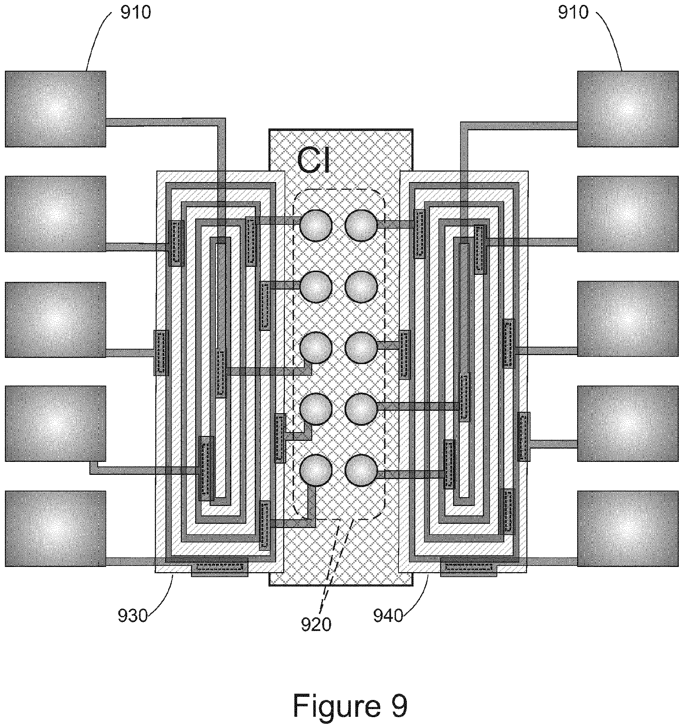

La figure 1 illustre le principe de réalisation d'une structure multicouche selon l'invention qui se fait en partant d'un substrat 110 ayant une partie de base comprenant possiblement une ou plusieurs couches dans la ou lesquelles on procède tout d'abord à la réalisation, avantageusement par une gravure, d'un motif 120 définissant la forme géométrique du creux ou cavité que l'on crée ainsi dans une portion 112 de l'épaisseur du substrat à partir de sa surface. Les figures 3 à 9 montrent plus complètement un exemple de forme de motif en creux dans lequel le motif comporte une partie de fond, ici plane et parallèle au plan du substrat 110, et une partie de flanc. Cette dernière rejoint la face du substrat depuis la partie de fond. En section suivant un plan parallèle au plan de la face du substrat 110, le motif peut notamment adopter un contour rectangulaire tel que le contour carré visible en figure 8 ou le profil allongé de la figure 9. La gravure est de préférence réglée pour que la cavité soit creusée avec au moins une portion inclinée 130, de préférence plane, de la partie de flanc.

Dans un premier mode de réalisation, l'inclinaison est telle que la portion inclinée 130 va en s'évasant jusqu'à la face du substrat 110.

Dans un autre mode de réalisation, l'inclinaison est inverse et la portion inclinée est rentrante, en direction de la face du substrat 110, relativement au fond de la cavité. Par exemple, l'angle du pan incliné 130 peut être compris entre 0° et 60° dans le premier cas et entre 0° et -60° dans le deuxième cas, relativement à la normale à la face du substrat 110.

Il peut y avoir plusieurs pans inclinés 130 espacés ou non sur la partie du flanc. Il peut par exemple s'agir des facettes, les facettes pouvant avoir des inclinaisons différentes. En outre, les pans inclinés ne sont pas forcément plans et on entend par pan incliné que la ou les couches sont, grâce au pan incliné, apte(s) à remonter depuis le fond du motif 120 jusqu'à la face du substrat 110, ce qui implique que le ou les pans 130 aient une composante non nulle suivant l'épaisseur du substrat 110 (la profondeur du motif 120). Dans un cas particulier, au moins un pan 130 peut avoir une forme curviligne en coupe suivant l'épaisseur du substrat 110, forme curviligne par exemple concave.

Dans le cas de pans 130 plans, vis-à-vis de la direction du plan de la face du substrat, l'angle de gravure 140 est typiquement compris entre 30° et 90°. Dans un cas limite de l'invention, la partie de fond est réduite à l'intersection des pans de la partie du flanc. Par exemple, on peut mettre en oeuvre une cavité en pyramide, pointe en bas, la partie du fond étant la pointe.

En particulier mais non exclusivement si la base du substrat 110, dans sa partie d'épaisseur recevant le motif 120, est électriquement conducteur et si la première des couches rapportées à sa surface 112 l'est, on dispose aussi une couche 150 participant ainsi au substrat avec le substrat de base et destinée à isoler électriquement du substrat 110 la structure multicouche ou empilement que l'on va former. On notera ici que la profondeur de la gravure 160 est avantageusement telle qu'elle est égale ou supérieure à l'épaisseur globale de l'empilement que l'on va former dans les étapes suivantes du procédé c'est-à-dire qu'elle doit être égale ou supérieure à la somme des épaisseurs des couples de couches isolant/conducteur composant l'empilement que l'on désire fabriquer.

Les matériaux utilisables pour former tout ou partie des éléments diélectriques de l'invention sont par exemple le silicium (Si) et son oxyde (SiO2) ou nitrure (SiN) qui sont des isolants. D'autres exemples sont donnés plus loin. Toutes les techniques connues de croissance, de dépôt et de gravure de ces matériaux et de tous ceux, conducteurs ou isolants, utilisés en microélectronique sont possiblement employées à partir de substrats le plus souvent constitués ou à base de silicium monocristallin qui se présentent sous la forme de tranches minces généralement qualifiées du terme anglais de « wafer ». La définition des motifs se fait notamment par photolithographie à partir de masques et par insolation, possiblement à partir d'un faisceau d'électrons (e-beam), de résines électrosensibles, voire par impression des motifs à partir de moules (nanoimprint).

Pour l'obtention du ou des pans inclinés 130, on pourra avoir recours typiquement à une gravure chimique de type KOH ou TMAH ou également à une gravure de type plasma laquelle est formée dans un réacteur de gravure où les dispositifs à graver sont exposés à celui-ci.

La figure 2 montre un exemple d'un empilement 200 de couches obtenu après dépôts alternés de couches conductrices 210, destinées à former les électrodes des capacités, et de couches isolantes 220 constituant le diélectrique de celles-ci. Comme on l'a vu, la couche 150 isole si besoin le tout du substrat 110, constitué de silicium dans cet exemple, et dans lequel on a d'abord procédé, préalablement aux dépôts ci-dessus, à la gravure du motif 120 et à la formation des flans inclinés 130. Comme indiqué précédemment, la profondeur de gravure est adaptée pour que la surface supérieure 201 de l'empilement des couches reste à un niveau inférieur 203 à celui des parties non gravées du substrat possiblement recouvert, comme dans cet exemple, par la couche isolante 150 complétant le substrat de base.

La formation de l'empilement 200 est configurée pour organiser une suite de couches conductrices (au moins une si le substrat est conducteur dans sa partie délimitant la cavité), cette suite de couches étant mise en commun avec des couches électriquement isolantes, de manière intermédiaire entre les couches conductrices de sorte que les couches conductrices sont isolées électriquement par les couches isolantes.

A titre d'exemple, les couches isolantes de l'empilement 200 peuvent être formées par dépôts ou traitements chimiques et notamment oxydation ou nitruration. Ainsi, les phases de dépôt peuvent par exemple être limitées à la création des couches conductrices, puis entre chaque dépôt une partie de leur épaisseur est traitée pour créer des couches isolantes.

On remarquera ici que les dépôts successifs des matériaux conducteurs et isolants sont de préférence adaptés pour être conformes c'est-à-dire qu'ils permettent d'obtenir des épaisseurs de dépôt sensiblement égales quelle que soit l'orientation des surfaces sur lesquelles le dépôt se produit. En particulier, les épaisseurs déposées sont sensiblement les mêmes sur le flanc du motif 120 qu'en dehors de celui-ci. Ce cas n'est cependant pas limitatif de l'invention et par exemple l'épaisseur peut être différente sur le ou les pans inclinés 130 relativement à la partie du fond.

La première couche de l'empilement formée couvre en totalité la cavité définie par le motif 120 en creux. Les couches suivantes recouvrent en totalité la surface de la couche précédente.

Les matériaux conducteurs constituant les électrodes 210 comprennent en particulier les métaux ou leurs alliages utilisés en microélectronique : l'aluminium (Al), l'or (Au), le cuivre (Cu), le platine (Pt) et possiblement toutes sortes de matériaux naturellement conducteurs ou rendus conducteurs, notamment par dopage comme les matériaux semi-conducteurs et en particulier le silicium dopé, ou les oxydes conducteurs. Le dépôt de ces matériaux peut se faire, en fonction du matériau, à l'aide de l'une ou l'autre des techniques communément utilisées par l'industrie de la microélectronique et qui sont le plus souvent désignées par les termes : PVD, CVD, PECVD et ALD, ECD, acronymes de l'anglais correspondant respectivement à « physical vapor déposition », « chemical vapor déposition », « Plasma-enhanced chemical vapor déposition », « atomic layer déposition », << electro-chemical déposition >>, c'est-à-dire «déposition physique en phase vapeur », «déposition chimique en phase vapeur », « déposition chimique en phase vapeur assistée par plasma », « déposition de couches atomiques », « dépôt électrochimiques ». Le dépôt peut se faire aussi par « spin coating » c'est-à-dire par centrifugation du matériau déposé sous forme liquide ou visqueuse à la surface du substrat. Les épaisseurs déposées sont typiquement comprises dans une gamme de valeurs allant de 0,2 µm (micromètre) à 2 µm.

Les matériaux pouvant constituer les couches diélectriques 220 comprennent : le nitrure de silicium (SiN), l'oxyde de silicium (SiO2), l'alumine (Al2O3), l'oxyde d'hafnium (HfO2), des céramiques comme le titano-zirconate de plomb (PZT) ou les titanates de baryum et de strontium (BST). Ils sont par exemple déposés avec les mêmes méthodes que celles mentionnées ci-dessus ou encore par PLD, acronyme de l'anglais « pulsed laser déposition », c'est-à-dire « dépôt par ablation laser pulsé ». Les épaisseurs déposées sont typiquement comprises dans une gamme de valeurs allant de 10 nm (nanomètre) à 2 µm.

La figure 3 montre un exemple de structure 310 avantageusement symétrique qui est obtenue à l'issue des étapes précédentes.

La figure 4 illustre le résultat de l'étape d'aplanissement jusqu'à un plan d'arrêt 420, de la surface des dispositifs qui est préférentiellement pratiquée à l'aide d'un polissage mécanique ou mécano-chimique 410 généralement désigné par l'acronyme CMP de l'anglais « chemical mechanical polishing ».

L'opération de CMP 410, ou d'une autre forme d'amincissement permettant le même résultat, donne ainsi accès, dans un seul et même plan 420, à toutes les couches de l'empilement 200 de couches qui a été formé lors des étapes précédentes. En particulier, on va pouvoir accéder à toutes ou partie des couches conductrices 210 par leurs tranches. En outre la tranche est accessible à tout niveau de la surface. Elle forme un contour sous forme de ligne fermé et parcourt donc toute la périphérie de la couche considérée. Préférentiellement, une couche conductrice supérieure, au-dessus du reste de l'empilement 200, ne nécessite pas une exposition de sa tranche et est accessible par sa surface supérieure formant la surface supérieure 201 de l'empilement 200.

On remarquera ici que l'angle d'inclinaison 140 du pan 130 de gravure du motif 120 initial contrôle la largeur de la tranche des couches métalliques qui sont devenues accessibles à partir de la surface 420 qui vient d'être aplanie. La largeur disponible 212 pour les reprises de contact dépend aussi de l'épaisseur 214 qui a été déposée lors de la formation de la couche conductrice correspondante. Elle est avantageusement plus large que celle-ci car elle est multipliée par l'inverse du sinus de l'angle 140 que forme le pan incliné 130 du motif initial avec le plan du substrat.

Par exemple, si l'angle de gravure 140 est de 45° et l'épaisseur 224 de la couche d'isolant déposée est de 0,15 µm, alors la section plane ou tranche 222 de cette couche en surface est de 0,2 µm. De même, si l'épaisseur 214 de la couche conductrice déposée est par exemple de 0,56 µm, alors la section plane ou tranche 212 de cette couche en surface est de 0,8 µm. Pour des couches conductrices et isolantes qui sont toutes respectivement avantageusement de mêmes épaisseurs, on obtient donc un pas de répétition qui est de 0,2 + 0,8 = 1 µm. Comme on va le voir dans la description des étapes suivantes, on va alors pouvoir ménager des reprises de contact dans les couches conductrices qui seront, par exemple, d'une largeur de 0,3 µm et qui pourront être séparées par un isolant sur une largeur de 0,7 µm dans ce cas. Le masque de photolithographie qui va préférentiellement permettre la reprise de contact sur les couches conductrices comme expliqué ci-après sera conçu en conséquence.

Le procédé de l'invention permet donc les reprises de contact individuelles sur chacune des couches conductrices 210 comme si les zones accessibles avaient été obtenues chacune séparément par photolithographie. Toute configuration électrique possible des capacités individuelles peut ainsi potentiellement être réalisée en une seule étape de photolithographie comme on va le voir ci-après et en particulier la mise en parallèle de ces dernières afin d'obtenir le maximum de capacité pour la surface du motif gravé.

La figure 5 montre le résultat de l'étape suivante où l'on vient déposer, après CMP, une couche 510 d'un isolant dans lequel on va pouvoir réaliser par photolithographie et gravure les ouvertures des reprises de contact qui vont donner accès à chacune des couches conductrices 210. La couche 510 est faite, par exemple, d'oxyde de silicium (SiO2) qui est, par exemple, déposé par PECVD sur une épaisseur de 200 nm.

La figure 6 montre le résultat de l'ouverture pour les reprises de contact dans la couche d'isolant 510 que l'on vient de déposer. Cette étape peut se faire à l'aide d'opérations de photolithographie classiques. Les motifs 612 et 614 qui définissent les ouvertures dans la couche d'isolant 510 sont d'abord transférés dans la couche 610 qui constitue un masque qui est fait, en fonction des matériaux à graver, soit de la résine photosensible que l'on a insolé à travers un masque ou un réticule de photolithographie et développé, soit d'un masque dit dur qui a lui-même été obtenu par photolithographie. L'un ou l'autre va permettre la gravure du matériau sous-jacent, de l'oxyde de silicium dans cet exemple. On remarquera ici que l'accès des couches conductrices est, dans cet exemple, réparti de part et d'autre de l'empilement 200 de couches afin de connecter une sur deux des couches conductrices de chaque côté et permettre la mise en parallèle de toutes les capacités individuelles dans cet exemple.

La figure 7 montre la réalisation des contacts de l'organe de connexion permettant des interconnexions à la surface du dispositif. Elle se fait préférentiellement après enlèvement du masque 610 et dépôt puis gravure d'une couche métallique qui assure un bon contact électrique sur les couches conductrices qui viennent d'être ouvertes. Les métaux utilisables comprennent le titane (Ti), le nickel (Ni), l'or (Au), l'aluminium (Al), le cuivre (Cu) et leurs combinaisons. La couche métallique déposée est avantageusement comprise dans une gamme d'épaisseurs allant de 0,5 à 2 µm. Les motifs des contacts, 710 et 720 dans cet exemple, sont par exemple définis d'une façon standard par photolithographie et gravure du matériau choisi.

La figure 8 est une vue de dessus d'un exemple de dispositif de type capacitif que l'on peut réaliser avec le procédé de l'invention. On y retrouve l'organe de connexion formé par deux contacts (appelés aussi reprises de contact) 710 et 720 qui apparaissent en coupe dans la figure précédente et qui sont situés sur des côtés opposés du contour de l'empilement 200. Les reprises de contact peuvent se faire aussi bien tout autour de la surface de l'empilement 200, comme par exemple avec le contact 810 disposé sur un côté de l'empilement 200 adjacent aux côtés dotés des contacts 710, 720.

Avantageusement, au moins un organe de connexion est, en surface, configuré pour offrir un raccordement électrique commun à plusieurs couches et il présente à cet effet une portion surfacique commune à plusieurs portions conductrices traversant chacune une ouverture. Dans le cas d'une capacité, une couche électrique sur deux est raccordée à un organe de connexion électrique, une autre série de couches électriques (l'autre alternance) étant raccordé à un autre organe électrique. Ainsi comme visible en figure 7, deux organes suffisent aux connexions de toutes les couches. Une grande liberté de forme et de placement des organes est offerte par l'invention étant rappelé que la tranche des couches est accessible en surface lors de l'étape de raccordement électrique vers les organes (710, 720, 810). Avec un organe (710, 720, 810) ayant une portion surfacique unique, on peut grâce à l'invention, raccorder des couches conductrices pourtant non successives et/ou ne pas raccorder dans une même zone de la surface du dispositif des couches successives pourtant affleurantes.

La figure 9 illustre un exemple d'utilisation de l'invention pour réaliser un routage de connexions à haute densité entre les plages 920 d'entrées/sorties d'un module contenant un circuit intégré (CI) et les plots de connexion 910 aptes à permettre de connecter le CI vers un circuit extérieur. Dans cet exemple on réalise deux empilements multicouches, 930 et 940 selon l'invention, qui permettent d'interconnecter plages et plots sans contraintes. Dans ce cas de figure, une même couche conductrice peut être raccordée à plusieurs contacts électriques de sorte à servir de ligne de routage entre plusieurs composants électriques.

Pour ce type d'application de l'invention, c'est-à-dire pour le routage haute densité d'interconnexions, il devient avantageux, au contraire de l'application précédente, de limiter les capacités entre les différentes pistes conductrices. Les empilements multicouches selon l'invention sont alors conçus pour limiter les surfaces en regard et utiliser des matériaux diélectriques à constante diélectrique faible comme l'oxyde de silicium (SiO2) par exemple. Par ailleurs, on utilise de préférence l'épaisseur maximale des couches diélectriques qui est permise par la technologie afin de diminuer les capacités parasites. Cela peut dépendre de la fréquence du signal transporté ; par exemple, une épaisseur supérieure à 1 µm est possible et avantageusement de quelques micromètres.

Outre les applications de routage décrites ci-dessus, les structures multicouches selon l'invention peuvent avantageusement être utilisées sous forme de capacités comme accumulateurs d'énergie ou éléments de filtrage dans de nombreux produits électroniques comme les alimentations électriques intégrées, les amplificateurs de signaux, les filtres de circuits radiofréquences (RF) et pour toutes sortes d'applications domestiques, ou par l'industrie automobile et celle des télécommunications où la miniaturisation amène des avantages de fiabilité et une réduction des coûts. Les dispositifs que l'on peut former peuvent s'inscrire dans des systèmes du type systèmes micro-électro-mécanique dits MEMS.

## Revendications

1. Procédé de réalisation d'un dispositif microélectronique comprenant un substrat (110) et un empilement (200) comprenant au moins une couche électriquement conductrice et au moins une couche diélectrique, comprenant les étapes suivantes :
- formation, à partir d'une face du substrat (110), d'au moins un motif (120) en creux par rapport à un plan de la face du substrat (110), la paroi du motif comportant une partie de fond et une partie de flanc, la partie de flanc étant située entre la partie de fond et la face du substrat (110),
- formation de l'empilement (200), les couches de l'empilement (200) participant à remplir au moins partiellement le motif (120), l'étape de formation de l'empilement (200) étant opérée sur toute la surface de la face du substrat (110),
- amincissement de l'empilement (200) au moins jusqu'au plan de la face du substrat de sorte à exposer en totalité la tranche de ladite au moins une couche électriquement conductrice en affleurement dans un plan (420),
- après l'amincissement, formation d'au moins un organe de connexion électrique (710, 720, 810) sur le substrat (110) en contact avec la tranche de ladite au moins une couche électriquement conductrice tout en laissant en totalité la tranche de ladite au moins une couche électriquement conductrice en affleurement dans ledit plan (420), la tranche formant alors un contour fermé en affleurement dans ledit plan (420), ledit organe de connexion électrique étant configuré pour former une reprise de contact individuelle sur tranche de ladite couche électriquement conductrice,
**caractérisé par le fait que** la partie de flanc de la paroi du motif est formée avec au moins un pan incliné (130) jusqu'à la face du substrat (110), le pan incliné présentant un angle d'inclinaison avec le plan de la face du substrat strictement compris entre 0° et 90° de sorte que la largeur (212) de la tranche soit plus grande que l'épaisseur (214) de ladite couche électriquement conductrice.

2. Procédé selon la revendication 1 dans lequel, la face du substrat étant électriquement conductrice, l'empilement (200) est formé sur le substrat (110) avec successivement au moins une alternance d'une couche isolante et d'une couche électriquement conductrice.

3. Procédé selon la revendication 1 dans lequel la paroi du motif (120) est électriquement isolante et l'empilement (200) est formé sur le substrat (110) avec successivement au moins une alternance d'une couche électriquement conductrice, d'une couche diélectrique et d'une couche électriquement conductrice.

4. Procédé selon l'une quelconque des revendications précédentes dans lequel le pan incliné (130) est formé d'une surface plane.

5. Procédé selon l'une quelconque des revendications précédentes dans lequel l'angle formé entre le pan incliné (130) et le plan de la face du substrat (110) est sélectionné entre 30° et 90°.

6. Procédé selon l'une quelconque des revendications précédentes, dans lequel l'étape de formation d'un organe de connexion électrique (710, 720, 810) comprend :
- le dépôt (510) d'un matériau électriquement isolant dans lequel on définit par photolithographie et gravure, pour au moins une tranche de couche électriquement conductrice exposée de l'empilement (200), au moins une ouverture (612, 614) pour permettre une reprise de contact électrique sur ladite tranche;
- le dépôt d'un matériau électriquement conducteur pour former l'organe de connexion électrique (710, 720, 810), ledit dépôt étant configuré pour traverser la au moins une ouverture (612, 614).

7. Procédé selon la revendication précédente dans lequel l'empilement comprend deux couches électriquement conductrices espacées par une couche diélectrique, la au moins une ouverture (612, 614) étant configurée pour permettre une reprise de contact sur la tranche d'une première des deux couches électriquement conductrices sans permettre une reprise de contact sur une deuxième des deux couches électriquement conductrices.

8. Procédé selon la revendication précédente comprenant une deuxième ouverture configurée pour permettre une reprise de contact sur la tranche de la deuxième des deux couches électriquement conductrices sans permettre une reprise de contact sur la première des deux couches électriquement conductrices.

9. Procédé selon l'une des revendications précédentes comprenant, avant la formation de l'empilement, et après formation du motif (120) en creux, la formation d'une couche électriquement isolante (150) finalisant le substrat (110).

10. Procédé selon l'une des revendications précédentes dans lequel l'étape de formation du motif (120) comprend une étape de gravure du substrat (110).

11. Procédé selon l'une des revendications précédentes pour la fabrication d'un dispositif capacitif multicouches.

12. Procédé selon l'une des revendications 1 à 10 pour la fabrication d'un dispositif de routage et/ou d'alimentation électrique d'un composant.

13. Procédé selon l'une quelconque des revendications précédentes dans lequel l'étape d'amincissement comprend un aplanissement.

14. Dispositif microélectronique comprenant un substrat (110) et un empilement (200) comprenant au moins une couche électriquement conductrice et une couche diélectrique, dans lequel le substrat (110) comporte un motif (120) en creux par rapport à un plan d'une face du substrat (110), la paroi du motif (120) comportant une partie de fond et une partie de flanc, la partie de flanc étant située entre la partie de fond et la face du substrat (110), motif (120) dans lequel est situé l'empilement (200), une première couche de l'empilement (200) couvrant intégralement la cavité définie par le motif (120), toute autre couche de l'empilement (200) couvrant intégralement une couche de l'empilement (200) qui lui est immédiatement sous-jacente, la tranche de la au moins une couche électriquement conductrice étant exposée en totalité à la face du substrat (110) en affleurement dans un plan (420) en formant un contour fermé en affleurement dans ledit plan (420), la tranche étant raccordée à un organe de connexion électrique (710, 720, 810) configuré pour former une reprise de contact individuelle sur ladite couche électriquement conductrice,
**caractérisé en ce que** la partie de flanc comporte au moins un pan incliné (130) jusqu'à la face du substrat (110), le pan incliné présentant un angle d'inclinaison avec le plan de la face du substrat strictement compris entre 0° et 90° configuré pour que la largeur (212) de la tranche soit plus grande que l'épaisseur (214) de ladite couche électriquement conductrice.

15. Dispositif selon la revendication précédente dans lequel l'organe de connexion électrique (710, 720, 810) comprend au moins un premier et un deuxième contacts électriques, chacun de ces contacts permettant de relier électriquement une série distincte de couches conductrices dudit empilement (200), chaque série distincte de couches conductrices formant une électrode de capacité ou un routage électrique.

16. Dispositif selon la revendication précédente dans lequel un des premier et deuxième contacts électriques (710, 720, 810) est raccordable à une plage d'entrée/sortie (920) d'un circuit intégré (CI) et l'autre des premier et deuxième contacts (710, 720, 810) est raccordable à au moins un plot de connexion (910) disposé sur le substrat (110).

17. Système comportant un circuit intégré (CI),doté d'au moins une plage d'entrée/sortie (920) et au moins un plot de connexion (910) et au moins un dispositif selon la revendication précédente dont un des premier et deuxième contacts électriques (710, 720, 810) est raccordé au plot de connexion (910) et un autre des premier et deuxième contacts électriques (710, 720, 810) est raccordé à ladite plage (920).

## Patentansprüche

1. Verfahren zur Herstellung einer mikroelektronischen Vorrichtung, die ein Substrat (110) und einen Stapel (200) umfasst, welcher mindestens eine elektrisch leitende Schicht und mindestens eine dielektrische Schicht umfasst, die folgenden Schritte umfassend:
- Bilden, ausgehend von einer Seite des Substrats (110), mindestens eines Musters (120), das in Bezug auf eine Ebene der Seite des Substrats (110) vertieft ist, wobei die Wand des Musters einen Bodenteil und einen Flankenteil umfasst, wobei sich der Flankenteil zwischen dem Bodenteil und der Seite des Substrats (110) befindet,
- Bilden des Stapels (200), wobei die Schichten des Stapels (200) dazu beitragen, das Muster (120) mindestens teilweise auszufüllen, wobei der Schritt des Bildens des Stapels (200) auf der gesamten Fläche der Seite des Substrats (110) vorgenommen wird,
- Dünnen des Stapels (200) mindestens bis zur Ebene der Seite des Substrats, um den Schnitt der mindestens einen elektrisch leitenden Schicht bündig in einer Ebene (420) vollständig freizulegen,
- nach dem Dünnen, Bilden mindestens eines elektrischen Verbindungsglieds (710, 720, 810) auf dem Substrat (110) in Kontakt mit dem Schnitt der mindestens einen elektrisch leitenden Schicht, während der Schnitt der mindestens einen elektrisch leitenden Schicht bündig in der Ebene (420) vollständig belassen wird, wobei der Schnitt dann bündig in der Ebene (420) eine geschlossene Kontur bildet, wobei das elektrische Verbindungsglied so ausgelegt ist, dass es eine individuelle Kontaktierung der elektrisch leitenden Schicht an dem Schnitt bildet,
**dadurch gekennzeichnet, dass** der Flankenteil der Wand des Musters bis zur Seite des Substrats (110) mit mindestens einem geneigten Teilstück (130) gebildet ist, wobei das geneigte Teilstück einen Neigungswinkel streng im Bereich zwischen 0° und 90° zur Ebene der Seite des Substrats aufweist, sodass die Breite (212) des Schnitts größer ist als die Dicke (214) der elektrisch leitenden Schicht.

2. Verfahren nach Anspruch 1, wobei, da die Seite des Substrats elektrisch leitend ist, der Stapel (200) auf dem Substrat (110) mit nacheinander mindestens einer Wechselfolge aus einer isolierenden Schicht und einer elektrisch leitenden Schicht gebildet wird.

3. Verfahren nach Anspruch 1, wobei die Wand des Musters (120) elektrisch isolierend ist und der Stapel (200) auf dem Substrat (110) mit nacheinander mindestens einer Wechselfolge aus einer elektrisch leitenden Schicht, einer dielektrischen Schicht und einer elektrisch leitenden Schicht gebildet wird.

4. Verfahren nach einem der vorstehenden Ansprüche, wobei das geneigte Teilstück (130) von einer ebenen Fläche gebildet wird.

5. Verfahren nach einem der vorstehenden Ansprüche, wobei der zwischen dem geneigten Teilstück (130) und der Ebene der Seite des Substrats (110) gebildete Winkel zwischen 30° und 90° gewählt wird.

6. Verfahren nach einem der vorstehenden Ansprüche, wobei der Schritt des Bildens eines elektrischen Verbindungsglieds (710, 720, 810) umfasst:
- das Abscheiden (510) eines elektrisch isolierenden Materials, wobei bei mindestens einem freiliegenden Schnitt einer elektrisch leitenden Schicht des Stapels (200) durch Fotolithografie und Ätzen mindestens eine Öffnung (612, 614) definiert wird, um eine elektrische Kontaktierung an dem Schnitt zu ermöglichen;
- das Abscheiden eines elektrisch leitenden Materials, um das elektrische Verbindungsglied (710, 720, 810) zu bilden, wobei die Abscheidung so ausgelegt ist, dass sie durch die mindestens eine Öffnung (612, 614) hindurchgeht.

7. Verfahren nach dem vorstehenden Anspruch, wobei der Stapel zwei elektrisch leitende Schichten umfasst, die durch eine dielektrische Schicht beabstandet sind, wobei die mindestens eine Öffnung (612, 614) so ausgelegt ist, dass sie eine Kontaktierung einer ersten der zwei elektrisch leitenden Schichten am Schnitt ermöglicht, ohne eine Kontaktierung an einer zweiten der zwei elektrisch leitenden Schichten zu ermöglichen.

8. Verfahren nach dem vorstehenden Anspruch, das eine zweite Öffnung umfasst, die so ausgelegt ist, dass sie eine Kontaktierung der zweiten der zwei elektrisch leitenden Schichten am Schnitt ermöglicht, ohne eine Kontaktierung an der ersten der zwei elektrisch leitenden Schichten zu ermöglichen.

9. Verfahren nach einem der vorstehenden Ansprüche, das vor dem Bilden des Stapels und nach dem Bilden des vertieften Musters (120) das Bilden einer elektrisch isolierenden Schicht (150) umfasst, die das Substrat (110) abschließt.

10. Verfahren nach einem der vorstehenden Ansprüche, wobei der Schritt des Bildens des Musters (120) einen Schritt des Ätzens des Substrats (110) umfasst.

11. Verfahren nach einem der vorstehenden Ansprüche zur Herstellung einer mehrschichtigen kapazitiven Vorrichtung.

12. Verfahren nach einem der Ansprüche 1 bis 10 zur Herstellung einer Vorrichtung zur Leitweglenkung und/oder Stromversorgung eines Bauteils.

13. Verfahren nach einem der vorstehenden Ansprüche, wobei der Schritt des Dünnens ein Abflachen umfasst.

14. Mikroelektronische Vorrichtung, die ein Substrat (110) und einen Stapel (200) umfasst, welcher mindestens eine elektrisch leitende Schicht und eine dielektrische Schicht umfasst,
wobei das Substrat (110) ein Muster (120) umfasst, das in Bezug auf eine Ebene einer Seite des Substrats (110) vertieft ist, wobei die Wand des Musters (120) einen Bodenteil und einen Flankenteil umfasst, wobei sich der Flankenteil zwischen dem Bodenteil und der Seite des Substrats (110) befindet, wobei sich der Stapel (200) in dem Muster (120) befindet, wobei eine erste Schicht des Stapels (200) den vom Muster (120) definierten Hohlraum gänzlich bedeckt, wobei jede andere Schicht des Stapels (200) eine Schicht des Stapels (200), die unmittelbar unter ihr liegt, gänzlich bedeckt, wobei der Schnitt der mindestens einen elektrisch leitenden Schicht an der Seite des Substrats (110) bündig in einer Ebene (420), unter Bildung einer in der Ebene (420) bündigen geschlossenen Kontur, vollständig freiliegt, wobei der Schnitt an ein elektrisches Verbindungsglied (710, 720, 810) angeschlossen ist, das so ausgelegt ist, dass es eine individuelle Kontaktierung an der elektrisch leitenden Schicht bildet,
**dadurch gekennzeichnet, dass** der Flankenteil bis zur Seite des Substrats (110) mindestens ein geneigtes Teilstück (130) umfasst, wobei das geneigte Teilstück einen Neigungswinkel streng im Bereich zwischen 0° und 90° zur Ebene der Seite des Substrats aufweist, der so ausgelegt ist, dass die Breite (212) des Schnitts größer ist als die Dicke (214) der elektrisch leitenden Schicht.

15. Vorrichtung nach dem vorstehenden Anspruch, wobei das elektrische Verbindungsglied (710, 720, 810) mindestens einen ersten und einen zweiten elektrischen Kontakt umfasst, wobei es jeder dieser Kontakte ermöglicht, eine separate Reihe leitender Schichten des Stapels (200) elektrisch miteinander zu verbinden, wobei jede separate Reihe leitender Schichten eine Kondensatorelektrode oder einen elektrischen Leitweg bildet.

16. Vorrichtung nach dem vorstehenden Anspruch, wobei einer aus dem ersten und zweiten elektrischen Kontakt (710, 720, 810) an eine Eingangs-/Ausgangs-Anschlussfläche (920) einer integrierten Schaltung (IC) angeschlossen werden kann, und der andere aus dem ersten und zweiten Kontakt (710, 720, 810) an mindestens ein Bondpad (910) angeschlossen werden kann, das auf dem Substrat (110) angeordnet ist.

17. System, das eine integrierte Schaltung (IC), die mit mindestens einer Eingangs-/Ausgangs-Anschlussfläche (920) und mindestens einem Bondpad (910) ausgestattet ist, und mindestens eine Vorrichtung nach dem vorstehenden Anspruch umfasst, von der einer aus dem ersten und zweiten elektrischen Kontakt (710, 720, 810) an das Bondpad (910) angeschlossen ist, und ein anderer aus dem ersten und zweiten elektrischen Kontakt (710, 720, 810) an die Anschlussfläche (920) angeschlossen ist.

## Claims

1. A method for producing a microelectronic device comprising a substrate (110) and a stack (200) comprising at least one electrically conductive layer and at least one dielectric layer, comprising the following steps:
- forming, from one face of the substrate (110), at least one pattern (120) recessed relative to a plane of the face of the substrate (110), the wall of the pattern including a bottom part and a sidewall part, the sidewall part being located between the bottom part and the face of the substrate (110),
- forming the stack (200), the layers of the stack (200) participating in at least partially filling the pattern (120), the step of forming the stack (200) being carried out over the entire surface of the face of the substrate (110),
- thinning the stack (200) at least to the plane of the face of the substrate so as to fully expose the wafer of said at least one electrically conductive layer flush in a plane (420),
- after thinning, forming at least one electrical connection member (710, 720, 810) on the substrate (110) in contact with the wafer of said at least one electrically conductive layer while leaving the entire wafer of said at least one electrically conductive layer flush in said plane (420), the wafer then forming a closed contour flush in said plane (420), said electrical connection member being configured to form an individual resumption of contact on the wafer of said electrically conductive layer,
**characterised in that** the sidewall part of the wall of the pattern is formed with at least one panel (130) inclined up to the face of the substrate (110), the inclined panel having an angle of inclination with the plane of the face of the substrate strictly comprised between 0° and 90° so that the width (212) of the wafer is greater than the thickness (214) of said electrically conductive layer.

2. The method according to claim 1 wherein, the face of the substrate being electrically conductive, the stack (200) is formed on the substrate (110) with successively at least one alternation of an insulating layer and an electrically conductive layer.

3. The method according to claim 1 wherein the wall of the pattern (120) is electrically insulating and the stack (200) is formed on the substrate (110) with successively at least one alternation of an electrically conductive layer, of a dielectric layer and an electrically conductive layer.

4. The method according to any one of the preceding claims, wherein the inclined face (130) is formed of a flat surface.

5. The method according to any one of the preceding claims, wherein the angle formed between the inclined panel (130) and the plane of the face of the substrate (110) is selected between 30° and 90°.

6. The method according to any one of the preceding claims, wherein the step of forming an electrical connection member (710, 720, 810) comprises:
- depositing (510) an electrically insulating material wherein at least one opening (612, 614) is defined by photolithography and etching, for at least one wafer of exposed electrically conductive layer of the stack (200), to allow resumption of electrical contact on said wafer;
- depositing an electrically conductive material to form the electrical connection member (710, 720, 810), said deposition being configured to pass through the at least one opening (612, 614).

7. The method according to the preceding claim wherein the stack comprises two electrically conductive layers spaced by a dielectric layer, the at least one opening (612, 614) being configured to allow resumption of contact on the wafer of a first one of the two electrically conductive layers without allowing resumption of contact on a second one of the two electrically conductive layers.

8. The method according to the preceding claim comprising a second opening configured to allow resumption of contact on the wafer of the second one of the two electrically conductive layers without allowing resumption of contact on the first one of the two electrically conductive layers.

9. The method according to one of the preceding claims comprising, before forming the stack, and after forming the recessed pattern (120), forming an electrically insulating layer (150) finalising the substrate (110).

10. The method according to one of the preceding claims, wherein the step of forming the pattern (120) comprises a step of etching the substrate (110).

11. The method according to one of the preceding claims for the manufacture of a multilayer capacitive device.

12. The method according to one of claims 1 to 10 for the manufacture of a routing and/or power supply device of a component.

13. The method according to any one of the preceding claims wherein the thinning step comprises a planarization.

14. A microelectronic device comprising a substrate (110) and a stack (200) comprising at least one electrically conductive layer and a dielectric layer, wherein the substrate (110) includes a pattern (120) recessed relative to a plane of a face of the substrate (110), the wall of the pattern (120) including a bottom part and a sidewall part, the sidewall part being located between the bottom part and the face of the substrate (110), pattern (120) wherein the stack (200) is located, a first layer of the stack (200) completely covering the cavity defined by the pattern (120), any other layer of the stack (200) completely covering a layer of the stack (200) immediately underlying it, the wafer of the at least one electrically conductive layer being fully exposed to the face of the substrate (110) flush in a plane (420) forming a closed contour flush in said plane (420), the wafer being connected to an electrical connection member (710, 720, 810) configured to form an individual resumption of contact on said electrically conductive layer,
**characterised in that** the sidewall part includes at least one panel (130) inclined up to the face of the substrate (110), the inclined panel having an angle of inclination with the plane of the face of the substrate strictly comprised between 0° and 90° configured so that the width (212) of the wafer is greater than the thickness (214) of said electrically conductive layer.

15. The device according to the preceding claim wherein the electrical connection member (710, 720, 810) comprises at least a first and a second electrical contact, each of these contacts allowing to electrically connect a distinct series of conductive layers of said stack (200), each distinct series of conductive layers forming a capacitor electrode or an electrical routing.

16. The device according to the preceding claim wherein one of the first and second electrical contacts (710, 720, 810) can be connected to an input/output area (920) of an integrated circuit (CI) and the other of the first and second contacts (710, 720, 810) can be connected to the at least one connection pad (910) disposed on the substrate (110).

17. A system including an integrated circuit (CI), provided with at least one input/output area (920) and at least one connection pad (910) and at least one device, according to the preceding claim, wherein one of the first and second electrical contacts (710, 720, 810) is connected to the connection pad (910) and another of the first and second electrical contacts (710, 720, 810) is connected to said pad (920).
